# EUROPEAN PATENT APPLICATION

(11) **EP 1 560 412 A1**
(43) Date of publication of application: **03.08.2005**
(21) Application number: 04001711.3
(22) Date of filing: 27.01.2004
(51) Int. Cl.: H04M 11/06, H04M 3/00, H03F 3/217

(54) **xDSL-Line-Interface-Circuit**

(71) Applicant: Infineon Technologies AG, 81669 München (DE)
(72) Inventor: Johansson, Carl-Mikael, 112 35 Stockholm (SE); Bokinge, Bo, 168 39 Bromma (SE); Barkarö, Stefan, 184 60 Äkersberga (SE); Karlsson, Lars, 194 34 Upplands Väsby (SE); Randahl, Torbjörn, 131 42 Nacka (SE); Wiesbauer, Andreas, 9210 Pörtschach (AT); Hauptmann, Jörg, 9241 Wernberg (AT)
(74) Representative: Reinhard - Skuhra - Weise & Partner GbR

(57) **Abstract**

xDSL-Line-Interface-Circuit having 4at least one self oscillating loop circuit which oscillates with a trimmed switching frequency (fₛ), wherein the self oscillating loop circuit (18, 19, 20) comprises a power amplifier (19) which is switched with said trimmed switching frequency (fₛ) and a loop filter (20) which feeds back an amplified loop signal output by said power amplifier (19) to an input of said power amplifier (19) and a trimming circuit (21) which varies continuously the trimmed switching frequency (fₛ) of said self oscillating loop circuit to spread a switching residual signal spectrum so that the power spectral density (PSD) of said switching residual signal is lower than a predetermined power spectral density.

## Description

The invention relates to an xDSL-Line-Interface-Circuit comprising a self-oscillating loop circuit with variable self oscillating frequency.

A usual subscriber line technology (DSL) offers fast data transfer on existing copper-based telephone lines. In DSL, broad-band data signals are transmitted on significantly higher frequencies than traditional narrow-band telephone signals. Since the narrow-band telephone signals and the broad-band data signals are both transmitted over the same subscriber line, splitter devices are provided for splitting and recombining the two types of signals at both ends of the subscriber line, i.e. at the central office or switching center, and at the end terminals at the subscriber location. There are various types of DSLs that have evolved over the last years such as ADSL, HDSL, MDSL, SDSL and VDSL. Multitone modulation is the basis of the DMT version of ADSL as well as some multi-carrier versions of VDSL. This type of modulation is also called orthogonal frequency division multiplexing (OFDM). In discrete multitone modulation (DMT), a given frequency range for data transmission is resolved into a number of narrow frequency bands for use as individual data links. In ADSL, data transmission occurs roughly between 20 kHz and 0.1 MHz.

In order to transmit the xDSL data signals over the telephone line which consists of a pair of copper wires, the central office must be provided with line drivers. The line driver compensates for the attenuation of the telephone line and has to comply with the PSD mask requirement of the DSL standard. The line driver amplifies the line-coded xDSL signal so that it is received downstream at the subscriber location with sufficient signal intensity. Similarly, the line drivers are provided at the subscriber locations for transmitting xDSL data upstream to the central office.

The basic component of each line driver is a power amplifier for amplifying the xDSL signal which is to be transmitted over the telephone line.

Conventional line drivers include linear class-B and AB amplifiers. However, the driving transistors in a class-AB amplifier are biased to operate in their linear region so that they are always in an on-state and draw quiescent current. This results in inefficient power dissipation.

Accordingly, it has been proposed to employ class-D amplifiers in xDSL line drivers to improve the power efficiency. The class-D amplifier according to the state of the art comprises a self-oscillating loop for generating a switching frequency and a preamplifier which receives an input signal from a signal source. The preamplifier and a comparator create a variable duty cycle square wave signal. As a consequence, a pulse train is created wherein the duty cycle is proportional to the level of the input signal. This pulse width modulated signal is coupled to the gates of two complementary output transistors. The source drain paths of the two copper transistors are connected in series between a supply voltage VDD and ground GND. In effect, the pulse width modulated signal with a duty cycle proportional to the input signal level turns complementary output transistors on and off with a switching frequency which is much greater than the frequency of the input signal. Hence, power is sufficiently delivered from the power supply to the load.

Line drivers employing class-D power amplifiers achieve higher power efficiency than conventional line drivers. The so-called switched mode line drivers are based upon a self-oscillating circuit core.

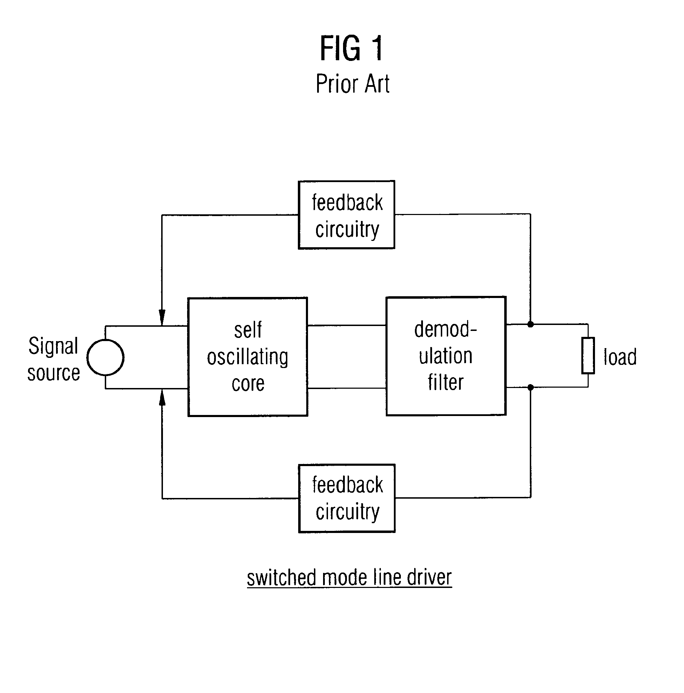

Fig. 1 shows a block diagram of a conventional broad-band line driver having a self-oscillating core. The self-oscillating core oscillates at a switching frequency of e.g. 10 MHz. The self-oscillating core switches the output stage with a switching frequency. A demodulation filter is provided at the output of the self-oscillating core for removing switching residuals from the output signal spectrum. Analog feedback is supplied outside the demodulation filter and fed back to the input of the self-oscillating core in order to define the gain of the amplifier and to adapt the termination impedance to the output of said line driver. At the input terminals of the self-oscillating core, the input signal generated by a signal source is superimposed on the feedback signals.

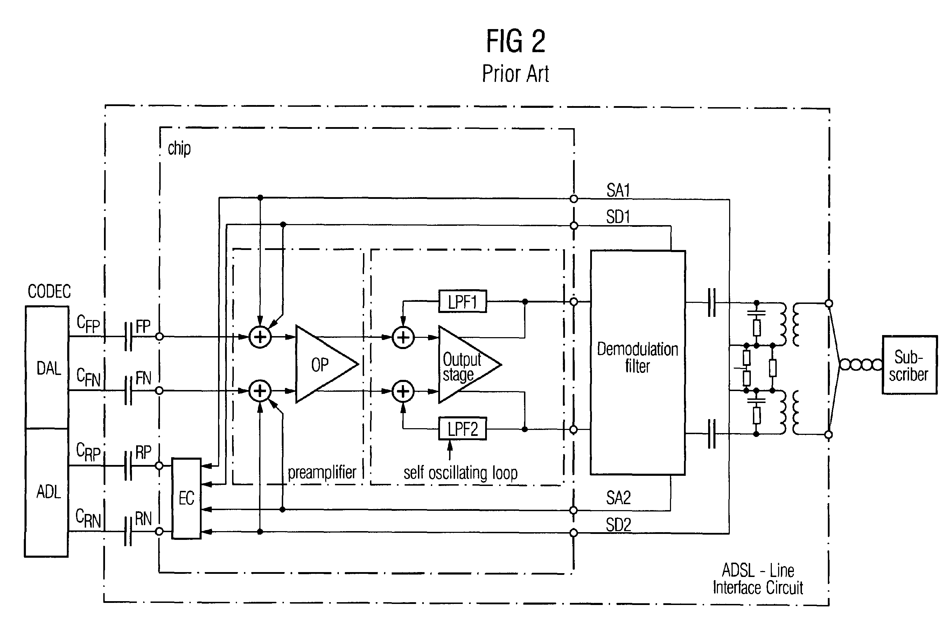

The analog line driver as shown in Fig. 2 according to the state of the art receives analog signals and outputs analog signals. However, the analog driver is built around a switched core where the switching frequency is dependent on the stability properties of the internal switched loop.

Fig. 2 shows a switched mode line driver such as in Fig. 1 in more detail. Fig. 2 shows an ADSL-line-interface-circuit connected to a CODEC circuit. The ADSL-line-interface-circuit can be used in the central office, DSLAM, DLC and MSAP applications. The ADSL interface circuit receives an analog input signal from a digital analog converter DAC of the CODEC via capacitors. The transmit input interface is a differential voltage interface. The ADSL-line-interface-circuit is connected to the output of the DAC via AC-coupling capacitors.

The ADSL-line-interface-circuit comprises one self-oscillating loop circuit. The oscillating loop circuit includes a switched output driver which is switched with a switching frequency fₛ of the oscillating loop circuit. The output of the switching output driver is fed back via a low-pass filter LPF1, LPF2 to adders which are connected to the inputs of the self-oscillating loop. The output of the switching output driver is connected to a demodulation filter. The demodulation filter is a low-pass filter. The output of the demodulation filter is fed back to the input of the oscillating core and applied to an analog adaption circuit for adapting the output impedance of the ADSL-line-interface-circuit to the impedance of the subscriber line.

The conventional ADSL-line-interface-circuit as shown in figure 2 comprises one self-oscillating loop circuit wherein the self-oscillating loop circuit has a loop signal which oscillates with a switching frequency fₛ. Both low-pass filters LPF are analog RC low-pass filters. The switching frequency fₛ of the oscillating loop circuit depends on the capacitance of the capacitors provided in both low-pass filters LPF1, LPF2.

One drawback of the ADSL-line-interface-circuit as shown in Fig. 2 is that the capacitance of the capacitors of the RC-low-pass filters LPF1, LPF2 is not adjustable. The switching frequency fₛ of the oscillating loop circuit depends on the capacitance of the low-pass filters. With increasing switching frequency fₛ, the current consumption of the ADSL-line-interface-circuit is increased. After production of the integrated ADSL-line-interface-circuit, the capacitance provided in the low-pass filters LPF1, LPF2 vary within certain limits so that the switching frequency fₛ of the self-oscillating loops is in many cases too high. As a consequence, the current consumption of the ADSL-line-interface-circuit according to the state of the art as shown in Fig. 2 varies in a broad range and is often too high.

In contrast a too low switching frequency fₛ degrades the performance of the ADSL-line interface circuit.

Another main disadvantage of the conventional xDSL-Line-Interface-Circuit of figure 2 is that there is a significant peaking in the output spectrum at the oscillation frequency of the self oscillating loop circuit. In many transmission systems, for example various xDSL systems, there are tough demands to keep the out of band signals within a predefined mask.

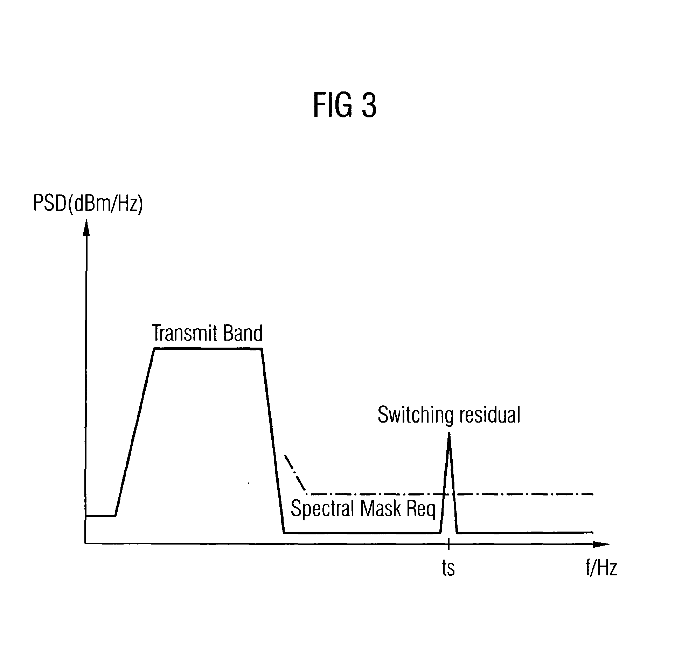

Figure 3 shows a typical output spectrum of a driver having a simple second order demodulation filter provided in an ADSL system. The power spectral density (PSD) is for normal ADSL - 40 dB/Hz in a transmit frequency band up to 1,1 MHz. In extended ADSL the power spectral density in the transmit band is -50 dB/Hz up to a frequency of 2,2 MHz (Still -40 up to 1.1MHz then -50 up to 2.2MHz) caused by the switching of the loop circuit a switching residual signal occurs at a frequency of e.g. 10 MHz having a power spectral density PSD which is higher than the spectral mask requirement of the xDSL standard. This problem occurs in particular when the xDSL-Line-Interface is in the idle mode after power up and no input signal is applied which is transmitted to the subscriber. Whereas in the normal operation mode the switching frequency fₛ is super-imposed to the applied xDSL input signal thus spreading the switching residual signal in the idle mode when no data is supplied as an input signal the switching residual signal is a peak signal at the switching frequency fₛ wherein the amplitude of the peak is higher than the admissible spectral mask requirement. Increasing the oscillation or switching frequency fₛ to overcome this problem has the disadvantage that the power consumption of the switching mode line driver is increased since the power consumption is linearly dependent on the switching frequency fₛ of the oscillation loop circuit.

Accordingly in conventional xDSL-Line-Interfaces to meet the mask requirements demodulation filters with high filter orders have been used to suppress switching residuals. For instance four order filters built with inductors and capacitors have been used as demodulation filters in an ADSL-Line-Interface-Circuit according to the state of the art as shown in figure 2. Further the leakage inductance of the line transformer is used in such high order demodulation filters. The use of high order filters as demodulation filters has the drawback that the technical complexity of the xDSL-Line-Interface-Circuit is increased. Further minimizing the size of the xDSL-Interface-Circuit and integration of said xDSL-Line-Interface-Circuit is becoming more difficult when the demodulation filter has a high filter order.

According it is the object to the present invention to provide an xDSL-Line-Interface-Circuit which has a low switching frequency to save power and which is still able to meet the spectral mask requirements for out of band noise without the use of an advanced external filter having a high filter order.

This object is achieved by an xDSL-Line-Interace-Circuit having the features of mainclaim 1.

The invention provides an xDSL-Line-Interface-Circuit having at least one self oscillating loop circuit which oscillates with a trimmed switching frequency (fₛ) wherein the self oscillating loop circuit comprises a power amplifier which is switched with said trimmed switching frequency and
a loop filter which feeds back an amplified loop signal output by said power amplifier to an input of said self-oscillating loop circuit and
a trimming circuit which after trimming varies the trimmed switching frequency of said self oscillating loop circuit to spread a switching residual signal spectrum so that the power spectral density (PSD) of said switching residual signal is lower than a predetermined power spectral density.

In a preferred embodiment the predetermined power spectral density (PSD) corresponds to a spectral mask requirement of an xDSL standard.

In a preferred embodiment the trimmed switching frequency is varied randomly within a predetermined frequency bandwidth.

In a preferred embodiment the predetermined frequency bandwidth has the range of the trimmed switching frequency plus/minus 10 per cent.

In a preferred embodiment the trimming circuit forms during a training sequence of said xDSL-Line-Interface-Circuit a trimming of switching frequency of said self oscillating loop.

In a further embodiment the switching frequency of said self oscillating loop circuit is controlled by the trimming circuit via at least one control line.

The preferred embodiment of the switching frequency of said self oscillating loop circuit is controlled by adjusting a timing device provided in said self oscillating loop circuit.

In a preferred embodiment the loop filter is an analog low-pass filter.

In a preferred embodiment the analog low pass filter is a RT-filter comprising at least one capacitor band and at least one resistor.

In a preferred embodiment the timing device has at least one capacitor comprising an adjustable capacitance.

In a preferred embodiment the timing device has at least one resistor comprising an adjustable resistance.

In a preferred embodiment the timing device has at least one delay unit comprising an adjustable delay time.

In a preferred embodiment the timing device has at least one voltage control oscillator (VCO) controlled by a DC-voltage.

In a preferred embodiment the timing device is the power amplifier comprising an adjustable transconductance.

In a preferred embodiment the switching frequency of the self oscillating loop circuit is controlled by said trimming circuit via one control line forming a serial interface.

In a preferred embodiment the timing device comprises a decoder which is connected to the serial interface to decode a serial control signal.

In a preferred embodiment the decoder controls switches for adjusting the capacitance of the adjustable capacitor.

In a preferred embodiment the switching frequency of said self oscillating loop circuit is controlled by the trimming circuit via several control lines forming a parallel interface.

In a preferred embodiment of the xDSL-Line-Interface-Circuit according to the present invention, the power amplifier is a class-D amplifier.

In a further embodiment of the xDSL-Line-Interface-Circuit according to the present invention, the trimming circuit is connected to said self-oscillating loop circuit for receiving the loop signal oscillating with said switching frequency.

In a preferred embodiment, the xDSL-Line-Interface-Circuit is an ADSL-line-interface-circuit.

In a further preferred embodiment of the xDSL-Line-Interface-Circuit according to the present invention, the trimming circuit performs the trimming of the switching frequency during a training sequence of the xDSL-Line-Interface-Circuit.

In a preferred embodiment of the xDSL-Line-Interface-Circuit according to the present invention, the trimming circuit comprises a control counter which counts the pulses of a reference clock signal.

In a preferred embodiment of the xDSL-Line-Interface-Circuit according to the present invention, the trimming circuit further comprises a switching frequency counter which counts the pulses of the loop signal.

In a preferred embodiment of the xDSL-Line-Interface-Circuit according to the present invention, the trimming circuit further comprises a first digital comparator which compares the count value of said switching frequency counter with a fixed first set count value.

In a further embodiment of the xDSL-Line-Interface-Circuit according to the present invention, said switching frequency counter is connected to said control counter for receiving a reset signal.

In a further embodiment of the xDSL-Line-Interface-Circuit according to the present invention, the first digital comparator is connected to said control counter for receiving a strobe signal.

In a further preferred embodiment of the xDSL-Line-Interface-Circuit according to the present invention, the trimming circuit comprises a timing device counter which is incremented by said first digital comparator when the count value of said switching frequency counter is smaller than the first set count value.

In a preferred embodiment of the xDSL-Line-Interface-Circuit according to the present invention, the trimming circuit comprises a status counter which is incremented by said first digital comparator when the count value of the switching frequency counter is higher or equal to the first set count value.

In a preferred embodiment of the xDSL-Line-Interface-Circuit according to the present invention, the trimming circuit comprises a second digital comparator which compares the count value of the status counter with a fixed second set count value.

In a preferred embodiment of the xDSL-Line-Interface-Circuit according to the present invention, the second digital comparator indicates the completion of the trimming when the count value of the status counter reaches the fixed second set count value.

In a preferred embodiment of the xDSL-Line-Interface-Circuit according to the present invention, the timing device counter is connected via the control lines to the at least one capacitor of said loop low-pass filter.

In a preferred embodiment of the xDSL-Line-Interface-Circuit according to the present invention, the timing device of said loop low-pass filter is decreased when the timing device counter is incremented for increasing the switching frequency of said loop signal.

In a preferred embodiment of the xDSL-Line-Interface-Circuit according to the present invention, the reference clock signal is a system clock signal.

In a preferred embodiment, the xDSL-Line-Interface-Circuit receives a differential input signal.

In a preferred embodiment of the xDSL-Line-Interface-Circuit according to the present invention, the differential input signal is applied to an analog comparator for generating a reference clock signal which is applied to the trimming circuit.

In a preferred embodiment of the xDSL-Line-Interface-Circuit according to the present invention, the analog comparator and the trimming circuit are activated by a time-enable signal.

In a preferred embodiment of the xDSL-Line-Interface-Circuit according to the present invention, the xDSL-Line-Interface-Circuit comprises a second order demodulation filter connected to said self-oscillating loop circuit.

In a preferred embodiment of the xDSL-Line-Interface-Circuit according to the present invention, the xDSL-Line-Interface-Circuit comprises an echo cancellation circuit.

In a preferred embodiment of the xDSL-Line-Interface-Circuit according to the present invention, the demodulation filter is connected to an analog adaption circuit for adapting the output impedance of said xDSL-Line-Interface-Circuit to a subscriber line.

In a preferred embodiment the timing device counter of the trimming circuit is activated by means of a variation enable signal (VE).

In a preferred embodiment the variation enable signal (VE) deactivates the first digital comparator of said trimming circuit.

In a preferred embodiment the trimming circuit is a DSP-processor.

The following preferred embodiments of the xDSL-Line-Interface-Circuit according to the present invention are described in detail with reference to the enclosed figures.
Fig. 1 shows a switched mode line driver according to the state of the art;
Fig. 2 shows an ADSL-line-interface-circuit according to the state of the art;
Fig. 3 shows a diagram of the output spectrum of a conventional xDSL-Line-Interface-Circuit according to figure 2 with a simple second order demodulation filter in an ADSL-system.
Fig. 4 shows an embodiment of the xDSL-Line-Interface-Circuit according to the present invention;
Fig. 5 shows a block diagram of a trimming circuit according to the present invention;
Fig. 6 shows a signal timing diagram for explaining the functionality of the trimming circuit of Fig. 5 according to the present invention;
Fig. 7 shows a flowchart of the operation of an xDSL-Line-Interface-Circuit according to the present invention;
Fig. 8 shows the switch frequencies trimmed depending on control signals according to preferred embodiment of the xDSL-Line-Interface-Circuit according to the present invention;
Fig. 9 shows a second embodiment of a self oscillating loop within an xDSL-Line-Interface-Circuit according to the present invention;
Fig. 10 shows third embodiment of a self oscillating loop within an xDSL-Line-Interface-Circuit according to the present invention;
Fig. 11 shows fourth embodiment of a self oscillating loop within an xDSL-Line-Interface-Circuit according to the present invention;
Fig. 12 shows the output spectrum of an xDSL-Line-Interface-Circuit according to the present invention.

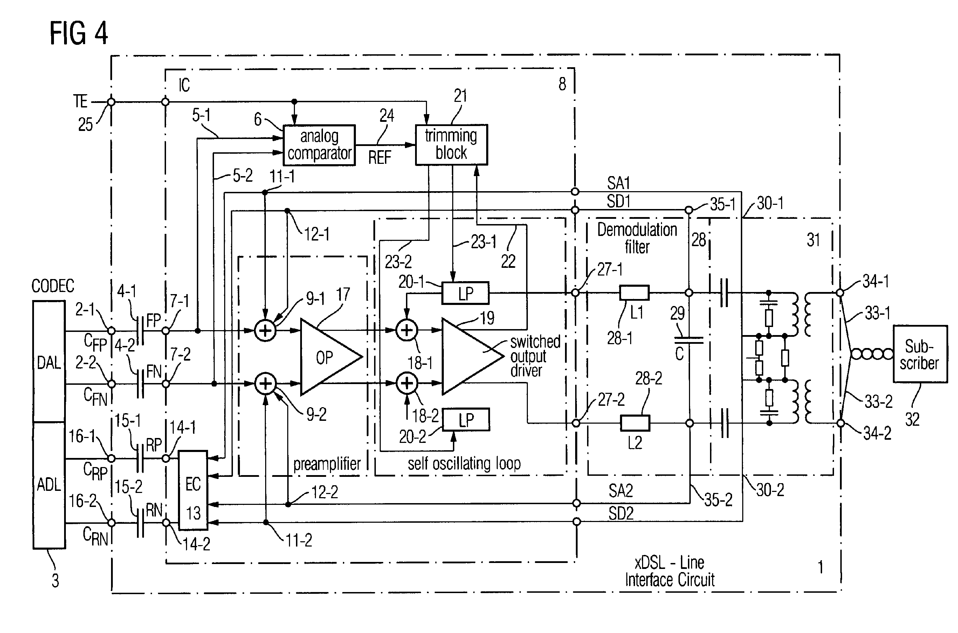

Fig. 4 shows a preferred embodiment of the xDSL-Line-Interface-Circuit 1 according to the present invention. The xDSL-Line-Interface-Circuit 1 as shown in Fig. 1 can be used preferably at a central office or as DSLAM, DLC and MSAP applications. The ADSL-line-interface-circuit 1 according to the present invention has a differential input terminal 2-1, 2-2 for receiving a differential analog input signal from a digital-analog converter DAC within a CODEC circuit 3. The differential input signal is applied via AC coupling capacitors 4-1, 4-2 and signal lines 5-1, 5-2 to an analog signal comparator 6. The differential analog input signal is applied to input terminals 7-1, 7-2 of an integrated circuit 8. The first differential input signal applied to the input terminal 7-1 is applied to an adder 9-1, which is connected to feedback nodes 11-1, 12-1. In the same manner, the second differential input signal applied to terminal 7-2 is supplied to an adders 9-2, which is connected to second feedback nodes 11-2, 12-2. The feedback terminals 11-1, 11-2, 12-1, 12-2 are further connected to an echo cancellation circuit 13 of the integrated circuit 8. The echo cancellation circuit 13 is connected to output terminals 14-1, 14-2 of the integrated circuit 8. In an ADSL system, the key performance parameter of the central office side is the signal-to-noise ratio (SNR) in the received frequency band. The echo cancellation circuit 13 is provided to maximize the signal-to-noise ratio and removes about 20 dB of the transmitted signal from the received signal path. Not only the transmitted fundamental tones are echo-cancelled, but also the noise and distortion of the whole driver circuit are cancelled in the received signal path.

The output terminals 14-1, 14-2 are connected via AC coupling capacitors 15-1, 15-2 to output terminals 16-1, 16-2 of the ADSL-line-interface-circuit 1 according to the present invention. The differential output terminal 16-1, 16-2 of the ADSL-line-interface-circuit 1 is connected to an analog-digital converter (ADC) within the CODEC 3.

The adders 9-1, 9-2 are connected to the input of a differential operational amplifiers 17 which is provided for signal amplification. The output of the differential amplifier 17 is connected to the switched self-oscillating loop having adders 18-1, 18-2 which are provided at the input side of a differential power amplifier 19. The power amplifier 19 is a class-D amplifier which is switched with a switching frequency fₛ. The output of the driver 19 is fed back via loop filters 20-1, 20-2 to the adders 18-1, 18-2. The loop filters 20-1, 20-2 feed back the amplified loop signal output by power the amplifier 19 to the input terminals of said amplifier 19. The adders 18-1, 18-2 the power amplifier 19 and the loop filters 20-1, 20-2 form a self oscillating signal loop wherein differential a loop signal oscillates with a switching frequency fₛ. The loop filters 20-1, 20-2 are analog low-pass filters. In a preferred embodiment, the analog low pass filters 20-1, 20-2 are formed by RC-analog filters wherein the capacitance of the capacitors provided within the RC-analog low-pass filters is adjustable.

The xDSL-Line-Interface-Circuit 1 according to the present invention comprises a trimming circuit 21 for trimming the switching frequency fₛ of the oscillating loop signals applied to the class-D amplifier 19. The trimming circuit 21 is connected to the output of the class-D amplifier 19 via a line 22 to receive a loop signal oscillating with the switching frequency fₛ. The trimming circuit 21 is further connected to the low-pass filters 20-1, 20-2 via control lines 23-1, 23-2. By means of the control lines 23-1, 23-2, the trimming circuit 21 is able to adjust the capacitance of the RC-analog low-pass filters 20-1, 20-2.

In the preferred embodiment as shown in Fig. 4, the trimming circuit 21 is connected to the output of the analog signal comparator 6 to receive the reference clock signal via line 24. In an alternative embodiment, the reference clock signal is a system clock signal.

The trimming circuit 21 and the analog comparator 6 are activated by a trim-enable signal (TE) which is applied to a control terminal 25 of the xDSL-Line-Interface-Circuit 1 according to the present invention. In a possible embodiment wherein the trimming of the oscillating loop is accomplished, this is indicated by the trimming circuit 21 via a trimming-o.k. signal which is output via the terminal 26 of the xDSL-Line-Interface-Circuit 1.

The trimming circuit 21 comprises as a further control input an input terminal 37 for receiving a variation enable control signal (VE). After the trimming of the switching frequency fₛ within the self oscillating loop circuit has been accomplished the trimming circuit 21 starts to vary the trimmed switching frequencies fₛ in the self oscillating loop circuits continuously to spread the switching residuals signal spectrum. By varying continuously the switching frequency fₛ the power spectral density (PSD) of the switching residual signal is lowered so that the spectral mask demands of the standard are met. The changing of the switching frequency is performed to change stability properties of the self oscillating loop circuit continuously so that a wider, lower peak at the out of band noise is achieved. The variation of the trimmed switching frequency ±fₛ is performed randomly within a predetermined frequency bandwidth. In a preferred embodiment the switching frequency is varied in a range of plus/minus 10 per cent of the switching frequency fₛ. By spreading of the residuals of the switching over a wider spectrum makes it is possible to use a demodulation filter 28 which has only a low filter order, (e.g. a filter order two) Do we need to state the order?. Consequently the technical complexity of a xDSL-Line-Interface-Circuit 1 according to the present invention is reduced in comparison to the conventional xDSL-Line-Interface-Circuit as shown in figure 2 which has an advanced demodulation filter of e.g. filter order four. Circuit 21 as shown in figure 4 is formed in a preferred embodiment by a DSP-processor.

In a preferred embodiment as shown in figure 4 the trimming and variation of this switching frequency is performed by adjusting capacitance for a capacitor within an analog RT-low-pass filters 20-1 and 20-2. In an alternative embodiment an adjustable resistor of the RT-analog low-pass filter is changed and perform the trimming and the variation of the switching frequency.

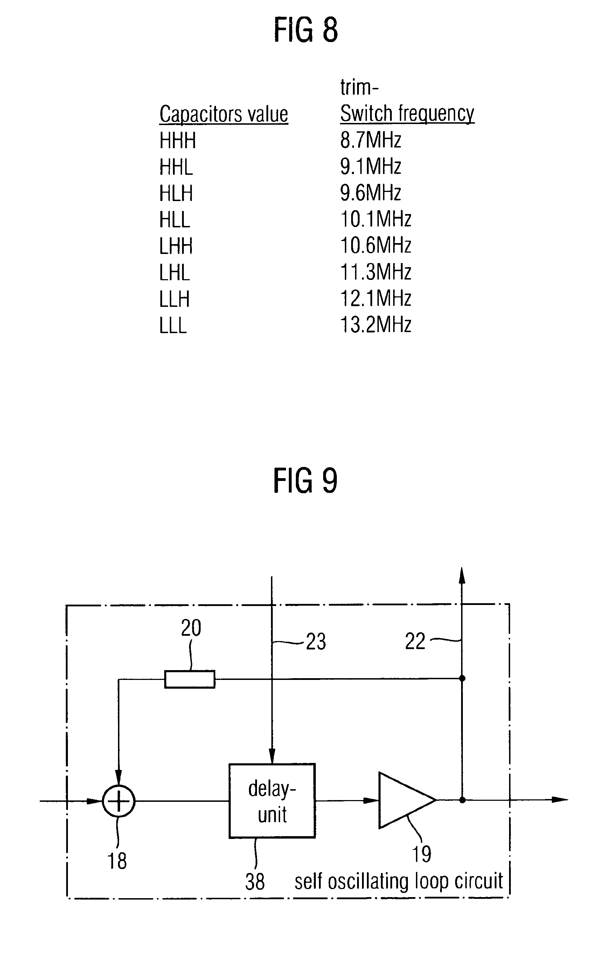

In further alternative embodiments as shown in figure 9 to 11 other timing devices within the oscillating loop circuits are adjusted by the trimming circuit 21.

In a preferred embodiment, the trimming circuit 21 performs the trimming of the switching frequencies of the oscillating loops during the training sequence of the xDSL-Line-Interface-Circuit 1.

The class-D amplifier 19 is connected at the output side to output terminals 27-1, 27-2 of the integrated circuit 8. The output terminals 27-1, 27-2 are connected to a demodulation filter 28. The demodulation filter 28 is a second order low-pass filter. The demodulation filter 28 as shown in Fig. 3 comprises a first inductance 28-1 and a second inductance 28-2 as well as a capacitor 29. On the output side the demodulation filter 28 is connected via first feedback lines 30-1, 30-2 to nodes 11-1, 11-2.

The xDSL-Line-Interface-Circuit 1 according to the present invention further includes a signal adaption circuit 31 for adapting the output impedance Z of the xDSL-Line-Interface-Circuit 1 to the subscriber line 32 which is connected with a pair of telephone lines 33-1, 33-2 to a differential signal output 34-1, 34-2 of the xDSL-Line-Interface-Circuit 1. Second signal feedback lines 35-1, 35-2 connect the terminals 12-1, 12-2 with the analog adaption circuit 31. The analog feedback is supplied to the inputs in order to define the signal gain of the amplifiers and to adapt the termination impedance to the output. At the input of the amplifier 17, the differential input signal of the xDSL-Line-Interface-Circuit 1 is superimposed on the feedback signals.

As can be seen from Fig. 4, the xDSL-Line-Interface-Circuit 1 according to the present invention is an analog signal driver having analog input signals and analog output signals wherein the analog driver is built around a switched core. The switching frequency fₛ of the switched core is dependent on the stability properties of the internal switched loop formed by the adder 18, the class-D amplifier 19 and the analog low-pass filter 20.

The power consumption of the xDSL-Line-Interface increases with the increasing switching frequency fₛ of the oscillating loop signals. The trimming circuit 21 of the xDSL-Line-Interface-Circuit 1 is provided for keeping the switching frequency fₛ within determined limits. With the trimming circuit 21, it is possible to fulfill certain standard requirements and to achieve cost-effective volume production. Such requirements are e.g. the SFDR (Spurious free dynamic range) and the MTPR (multitone power ratio).

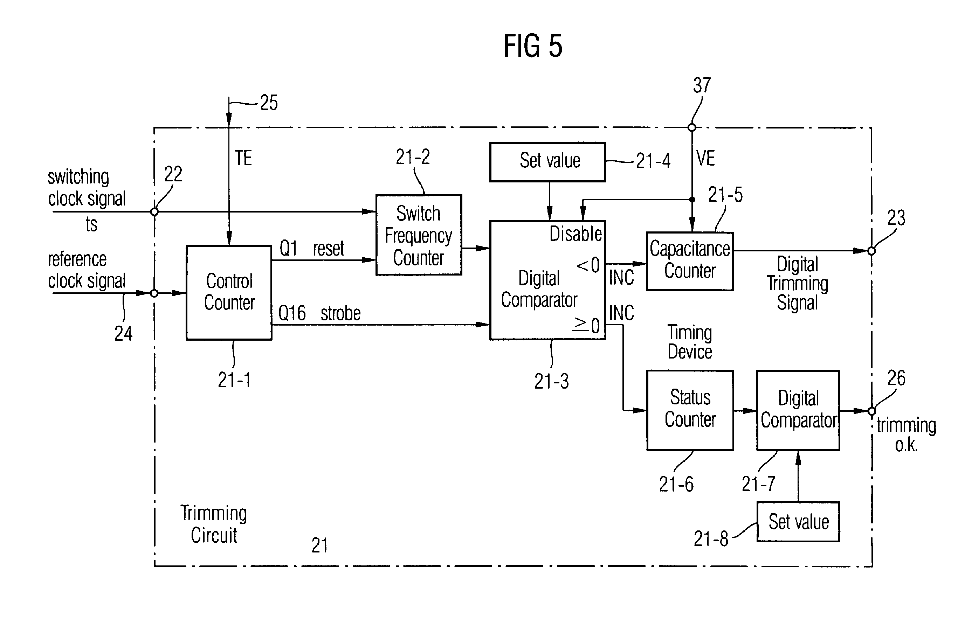

Fig. 5 shows the trimming circuit 21 according to the present invention in more detail. The trimming circuit 21 comprises a control counter 21-1, a switched frequency counter 21-2 and a digital comparator 21-3. The control counter 21-1 counts the signal pulses of a reference clock signal applied via line 24 to the trimming circuit 21. In the preferred embodiment shown in Fig. 3, the reference clock signal is the output signal of the analog comparator 6 which compares different analog input signals applied to the terminals 2-1, 2-2 of the xDSL-Line-Interface-Circuit 1. In an alternative embodiment, the reference clock signal is a system clock signal. The switching frequency fₛ of the self-oscillating loop is measured at a fixed clock interval wherein the clock interval is determined by the use of the reference clock signal.

After a power-up, the trimming is enabled through the trim-enable signal TE enabling the trimming circuit 21. The control counter 21-1 counts in a preferred embodiment 16 pulses wherein after the first pulse of the reference clock signal the switching frequency counter 21-2 is reset. The number of pulses of the self-oscillating loop is counted by the switching frequency counter 21-2 during the clock interval of the reference clock signal. The output of the switching frequency counter 21-2 is connected to a first input of the digital comparator 21-3. The digital comparator 21-3 compares the count value of the switching frequency counter 21-2 with a fixed first set count value stored in a memory 21-4 of the trimming circuit 21. When the count value of the switching frequency counter 21-2 is smaller than the first set count value, i.e. when the difference is lower than zero, the timing device counter 21-5 of the trimming circuit 21 is incremented by the digital comparator 21-3. The timing device counter 21-5 applies a digital trimming signal to capacitors of the low-pass filters 20-1, 20-2 to adjust the capacitance of said capacitors. With the increasing count value of the timing device counter 21-5, the capacitance of the RC low-pass filters 20-1, 20-2 is decreased to increase the switching frequency fₛ of the oscillating loops.

When the number of pulses of the self-oscillating loop signal counted during the predetermined clock interval of the reference clock signal is higher or equal to the set count value stored in memory 21-4, it is decided by the comparator 21-3 that the desired set frequency fₛ₋ₛₑₜ has been reached and a status counter 21-6 of the trimming circuit 21 is incremented. To make sure that the decision is correct, the second digital comparator 21-7 of the trimming circuit 21 is provided and compares the count value of the status counter 21-6 with a second set count value memorized in a memory 21-8 of the trimming circuit. If the count value of the status counter 21-6 has reached the second set value, e.g. the set value of 8, it is decided by the digital comparator 21-7 that trimming has been accomplished and in a possible embodiment the digital comparator 21-7 outputs the trimming-o.k. signal to an output terminal 26 of the ADSL-line-interface-circuit 1.

After the trimming has been accomplished the trimming circuit 21 as shown in figure 5 receives a variation enable control signal (VE) which enables the timing device counter and which disables the digital comparator 21-3. The digital comparator 21-3 is deactivated so that the timing device counter 21-5 is not digital incremented by the digital comparator 21-3. After the timing device counter 21-5 has received the variation enable signal (VE) it starts to vary continuously the trimmed switching frequency fₛ by adjusting the connected timing device which is in a preferred embodiment an adjustable capacitance of the low-pass filter 20-i. The timing device counter 21-5 sets the switching frequency fₛ to the next value. There can be any number of frequency steps wherein the order of change between the frequency steps can be a rising order, a falling order or an hazardous order.

In a preferred embodiment the trimmed switching frequency fₛ is varied randomly within a predetermined frequency band. The range of the predetermined frequency band is e.g. the switching frequency plus/minus 10 per cent. The setting to another frequency value is implemented in a first embodiment via a serial interface and in an alternative embodiment with a parallel interface. When using serial interface the timing device includes in a preferred embodiment a decoder to decode a serial input control signal. The decoder controls switches to increase for instance the capacitance or resistance of the analog low-pass filter 20. The switching frequency fₛ is changed during the operation of the xDSL-Line-Interface-Circuit between a number of frequency values. The number of frequencies to switch between can be any number and the time interval between the frequency changes can be choosen freely as long as the frequency of the change is lower than the self oscillating frequency itself.

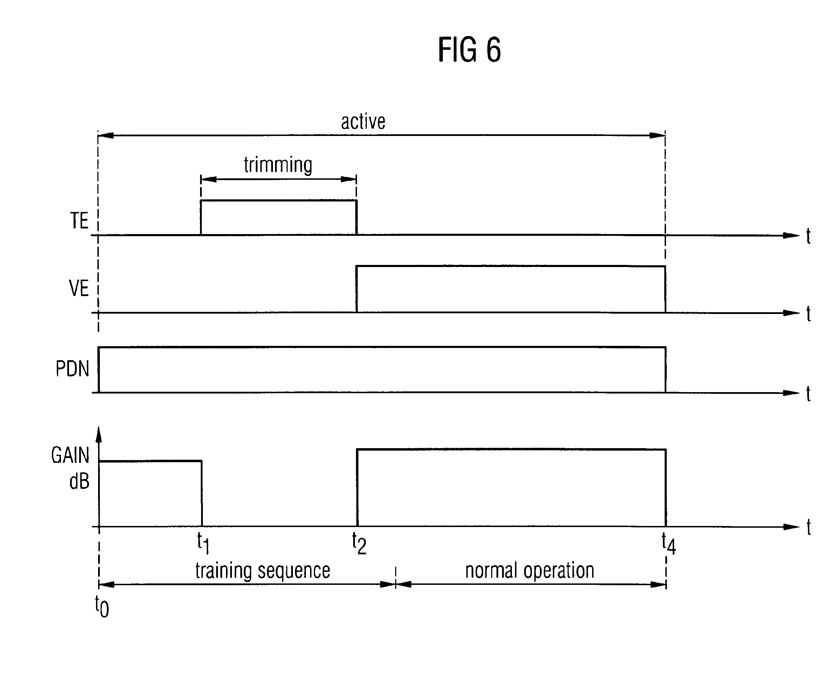

Fig. 6 shows the timing of the trimming and the variation of the trimmed switching frequencies performed by the trimming circuit 21.

At to, the xDSL-Line-Interface-Circuit 1 is activated when a power-down PDN control signal goes high. The xDSL-Line-interface-Circuit 1 performs a training sequence when the trim-enable signal TE goes high. In a preferred embodiment, the trimming is started about 1 ms after the PDN input is high. When the trimming is enabled, the transmit signal gain is set to 0 dB independent from the gain in the active mode. In a preferred embodiment, the default value of the switched frequency is set to 10.5 MHz. During the trimming interval between t1, t2, the trimming is performed by sending a reference signal from the CODEC 3 to the input terminals 2-1, 2-2 of the xDSL-Line-Interface-Circuit 1. In a preferred embodiment, the reference clock signal is a sinus 30 mVᵣₘₛ ± 5 mVᵣₘₛ at a frequency of 1.104 MHz. The trimming lasts, in a preferred embodiment, approximately 1 ms. The counters which control the capacitance of the low-pass filters 20-1, 20-2 in the switched loop keep their counting values as long as the PDN input is high.

At t₂ a variation enable control signal (VE) goes high and the switching frequencies fₛ in the internal loop circuits is changed continuously during the normal operation to spread the switching residual signal spectrum.

The preferred embodiments of the capacitance of the RC-analog low-pass filters in the self-oscillating loops consist of binary weighted capacitor units which are controlled by a three-bit control line 23. Fig. 8 shows switching frequencies fₛᵢ corresponding to a three-bit digital control signal in a preferred embodiment of the xDSL-Interface 1 according to the present invention.

The fourth value of the switching frequency LHH corresponds to a switching frequency of 10.6 MHz. The range of the switching frequency is 8.7 to 13.2 MHz which is controlled by the capacitors in the low-pass filters of the switched loops. In a preferred embodiment, the step of the self-oscillating frequency is 700 kHz. The timing device counter 21-5 steps down the capacitor value of the low-pass filter 20 as long as the self-oscillating frequency fₛ is lower than the tuning frequency.

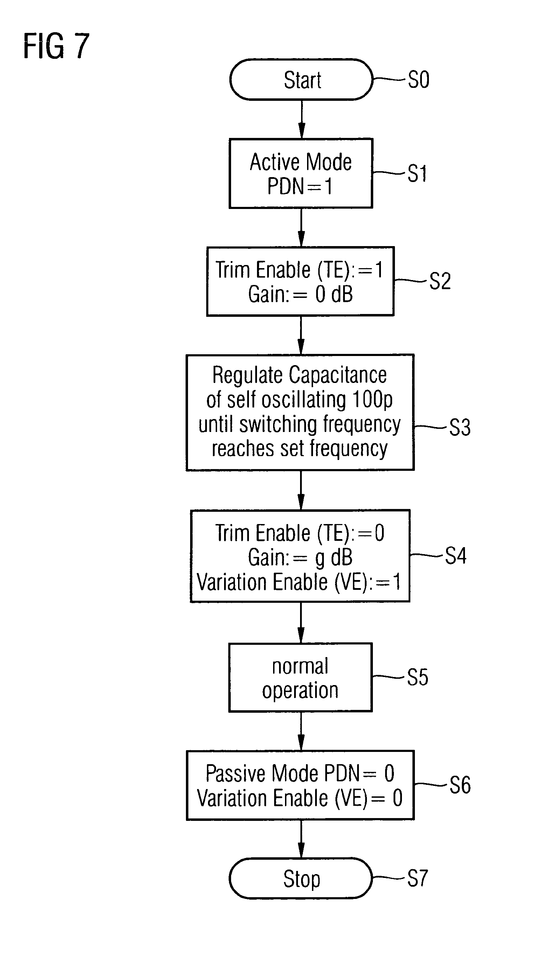

Fig. 7 shows a flowchart of the trimming procedures according to the present invention.

After the start at step S₀, the xDSL-Line-Interface-Circuit 1 is activated by setting the power-down control signal PDN to high at step S1. Trimming is enabled at step S2 by setting a trim-enable control signal (TE) to high and setting the gain of the amplifier to 0 dB.

In step S3, the capacitance of the self-oscillating loop is regulated until the switching frequency fₛ reaches a set switching frequency fₛ₋ₛₑₜ.

In a step S4, the trim-enable control signal (TE) is reset and the power amplifier amplifies the input signal with a predetermined signal gain. The variation enable control signal (VE) goes high so that the switching frequency of the self oscillating loop circuit is changed continuously.

In step S5, die xDSL-Line-Interface-Circuit 1 is operated in a normal operation mode. By setting the PDN control signal, the xDSL-Line-Interface-Circuit 1 is deactivated in step S6, and the procedure stops in step S7.

The trimming circuit 21 starts the trimming of the capacitance of the low-pass filters 20-1, 20-2 with a low switching frequency fₛ and increments the switching frequency fₛ by decreasing the capacitance of the RC low-pass filters 20-1, 20-2. The switching frequency fₛ is increased until a desired set switching frequency fₛ value is reached. The trimming circuit 21 makes sure that a switching frequency fₛ within the loop circuits does not exceed the desired switching frequency fₛ so that the current consumption of the xDSL-Line-Interface-Circuit 1 does not exceed the necessary minimum current consumption which is proportional to the switching frequency fₛ of the loop circuits.

In the preferred embodiment shown in Fig. 4, one of the tones of the DMT-signal spectrum is used as a reference signal and applied to the analog comparator 6. The trimming circuit 21 performs the trimming during the training sequence of the xDSL-Line-Interface-Circuit 1 wherein a single tone of the DMT-transmit signal spectrum is used as a reference frequency. According to the preferred embodiment shown in Fig. 4, no system reference clock signal is necessary. The trimming is only performed when a trim-enable control signal (TE) is high. If no trimming is performed after the power supply is on, the switching frequency is set to a default value, e.g. 10.5 MHz ± 1.5 MHz.

The trimming of the analog low-pass RC filters allows a higher variation of the manufacturing process and a higher variation of the temperature T. Consequently, the xDSL-Line-Interface-Circuit 1 according to the present invention is more robust against process deviations and temperature changes.

The trimming by the trimming circuit 21 can be performed at any time to compensate changes of the environmental conditions such as temperature changes which might affect the switching frequency of the oscillating loop circuits.

Fig. 9 shows a second embodiment of the self oscillating loop circuit wherein the timing device controlled by the trimming circuit 21 is formed by a delay unit 38. By changing the delay time of the delay unit 38 which is provided at the input side of the power amplifier 19 the switching frequency of the self oscillating loop circuit as shown in figure 9 is controlled. By increasing the delay time Δt of the delay unit 38 the switching frequency fₛ of the self oscillating loop circuit is decreased.

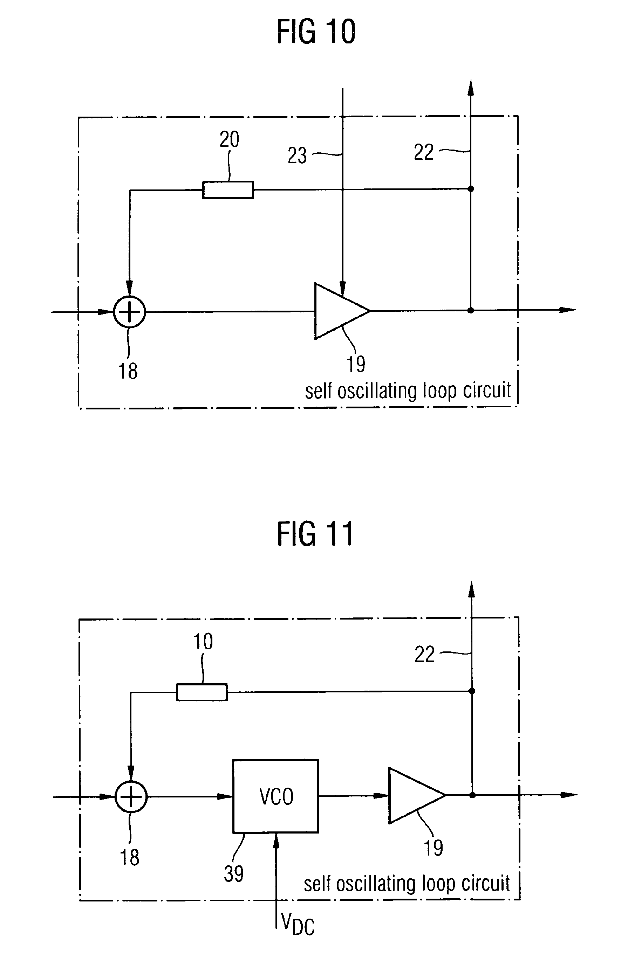

Fig. 10 shows a third embodiment of a self oscillating loop circuit as used in an xDSL-Line-Interface-Circuit 1 according to the present invention wherein the switching frequency fₛ is controlled by changing the trans-conductance gₘ of the power amplifier 19.

Fig. 11 shows a fourth embodiment of a self oscillating loop circuit as used in an xDSL-Line-Interface-Circuit according to the present invention wherein a voltage control oscillator 39 is provided which is controlled by an external DC-voltage. By increasing the DC-voltage the switching frequency fₛ of the self oscillating loop circuit is increased.

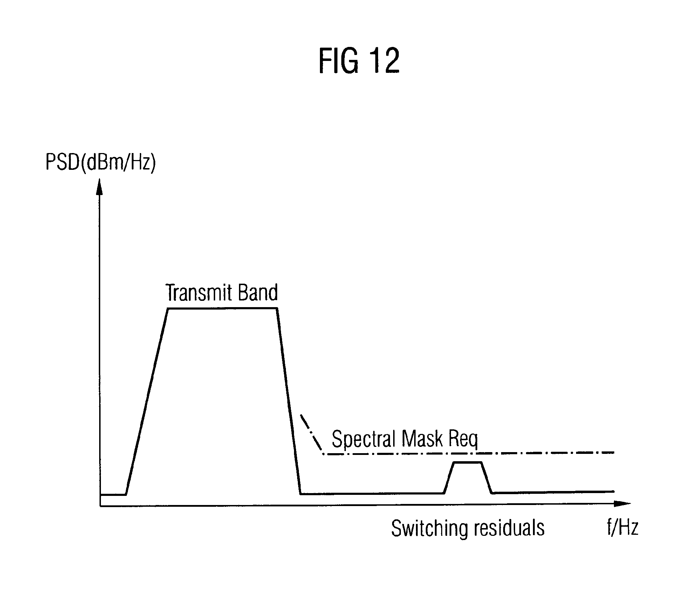

Fig. 12 shows the output spectrum of the xDSL-Line-Interface-Circuit 1 according to the present invention. As can be seen from figure 12 by changing the switching frequency fₛ of the self oscillating loop circuit continuously the out of band residual is spread over a wider spectrum so that the amplitude becomes lower than the predetermined power spectral density PSD according to the xDSL-standard. The standard is fulfilled without the use of a demodulation filter 28 of a high filter order.

### Reference List

- 1: xDSL-Line-Interface-Circuit
- 2: differential input
- 3: CODEC circuit
- 4: coupling capacitors
- 5: lines
- 6: analog comparator
- 7: input terminals
- 8: integrated circuit
- 9: adders
- 10: -
- 11: feedback input terminal
- 12: feedback input terminal
- 13: echo cancellation unit
- 14: output terminals
- 15: output coupling capacitors
- 16: differential output
- 17: operational amplifier
- 18: adders
- 19: class-D amplifier
- 20: low-pass filters
- 21: trimming circuit
- 22: switching frequency measuring line
- 23: trimming control lines
- 24: reference signal line
- 25: trim-enable input
- 26: trimming-o.k. output
- 27: output terminals
- 28: demodulation filter
- 29: capacitor
- 30: feedback lines
- 31: analog adapting circuit
- 32: subscriber line
- 33: twisted pair telephone lines
- 34: xDSL-line-interface-circuit output terminal
- 35: feedback lines
- 37: variation enable control signal input
- 38: delay unit
- 39: voltage control oscillator

## Claims

1. xDSL-Line-Interface-Circuit having:
a) at least one self oscillating loop circuit which oscillates with a trimmed switching frequency (fₛ), wherein the self oscillating loop circuit (18, 19, 20) comprises:
a1) a power amplifier (19) which is switched with said trimmed switching frequency (fₛ) and
a2) a loop filter (20) which feeds back an amplified loop signal output by said power amplifier (19) to an input of said power amplifier (19); and
b) a trimming circuit (21) which varies continuously the trimmed switching frequency (fₛ) of said self oscillating loop circuit to spread a switching residual signal spectrum so that the power spectral density (PSD) of said switching residual signal is lower than a predetermined power spectral density.

2. xDSL-Line-Interface-Circuit according to claim 1, wherein the predetermined power spectral density corresponds to a spectral mask requirement of a xDSL standard.

3. xDSL-Line-Interface-Circuit according to claim 1, wherein the trimmed switching frequency is varied randomly within a predetermined frequency bandwidth.

4. xDSL-Line-Interface-Circuit according to claim 3, wherein the predetermined frequency bandwidth has a range of the trimmed switching frequency plus/minus 10 per cent.

5. xDSL-Line-Interface-Circuit according to claim 1, wherein the trimming circuit (1) performs during a training sequence of said xDSL-Line-Interface-Circuit (21) a trimming of the switching frequency of said self oscillating loop.

6. xDSL-Line-Interface-Circuit according to claim 1, wherein the switching frequency (fₛ) of said self oscillating loop circuit is controlled by said trimming circuit (21) via at least one control line (23).

7. xDSL-Line-Interface-Circuit according to claim 1, wherein the switching frequency (fₛ) of said self oscillating loop circuit is controlled by adjusting a timing device (20; 38; 19; 39) provided in said self oscillating loop circuit.

8. xDSL-Line-Interface-Circuit according to claim 1, wherein said loop filter (20) is an analog low pass filter.

9. xDSL-Line-Interface-Circuit according to claim 8, wherein the analog low pass filter (20) is a RC-filter comprising at least one capacitor and at least one resistor.

10. xDSL-Line-Interface-Circuit according to claim 7, wherein the timing device (20) has at least one capacitor comprising an adjustable capacitance.

11. xDSL-Line-Interface-Circuit according to claim 7, wherein the timing device (20) has at least one resistor comprising an adjustable resistance.

12. xDSL-Line-Interface-Circuit according to claim 7, wherein the timing device has at least one delay unit (38) comprising an adjustable delay time.

13. xDSL-Line-Interface-Circuit according to claim 7, wherein the timing device has at least one voltage control oscillator (39) controlled by a DC-voltage.

14. xDSL-Line-Interface-Circuit according to claim 7, wherein the timing device is the power amplifier (19) (comprising an adjustable trans-conductance (gₘ)).

15. xDSL-Line-Interface-Circuit according to claim 6, wherein the switching frequency (fₛ) of said self oscillating loop circuit is controlled by said trimming circuit (21) via one control line forming a serial interface.

16. xDSL-Line-Interface-Circuit according to claim 15, wherein the timing devices comprises a decoder which is connected to a serial interface to decode a serial control signal.

17. xDSL-Line-Interface-Circuit according to claim 16, wherein the decoder controls switches for adjusting the capacitance of an adjustable capacitor.

18. xDSL-Line-Interface-Circuit according to claim 6, wherein the switching frequency (fₛ) of said oscillating loop circuit is controlled by said trimming circuit (21) via serial control lines forming a parallel interface.

19. xDSL-Line-Interface-Circuit according to claim 1, wherein the power amplifier (19) is a class-D-amplifier.

20. xDSL-Line-Interface-Circuit according to claim 1, wherein said trimming circuit (21) is connected via a line (22) to said self oscillating loop circuit for receiving the loop signal oscillating with said switching frequency (fs).

21. xDSL-Line-Interface-Circuit according to claim 1, wherein said xDSL-Line-Interface-Circuit (1) is an ADSL-Line-Interface-Circuit.

22. xDSL-Line-Interface-Circuit according to claim 1, wherein the trimming circuit (21) comprises a control counter (21-1) which counts the pulses of a reference clock signal.

23. xDSL-Line-Interface-Circuit according to claim 22, wherein said trimming circuit (21) further comprises a switch frequency counter (21-2) which counts pulses of the loop signal.

24. xDSL-Line-Interface-Circuit according to claim 23, wherein said trimming circuit (21) further comprises a first digital comparator (21-3) which compares the count value of said switch frequency counter (21-2) with a fixed first set count value.

25. xDSL-Line-Interface-Circuit according to claim 23, wherein said switch frequency counter (21-2) is connected to said control counter (21-1) for receiving a reset signal.

26. xDSL-Line-Interface-Circuit according to claim 24, wherein the first digital comparator (21-3) is connected to said control counter (21-1) for receiving a strobe signal.

27. xDSL-Line-Interface-Circuit according to claim 26, wherein the trimming circuit (21) comprises a timing device counter (21-5) which is incremented by said first digital comparator (21-3) when the count value of said switching frequency counter (21-2) is smaller than the first set count value.

28. xDSL-Line-Interface-Circuit according to claim 27, wherein the trimming circuit (21) comprises a status counter (21-6) which is incremented by said first digital comparator (21-3) when the count value of said switch frequency counter (21-2) is higher or equal to the first set count value.

29. xDSL-Line-Interface-Circuit according to claim 28, wherein the trimming circuit (21) comprises a second digital comparator (21-7) which compares the count value of said status counter (21-6) with a fixed second set count value.

30. xDSL-Line-Interface-Circuit according to claim 29, wherein said second digital comparator (21-7) indicates the completion of the trimming when the count value of said status counter reaches the fixed second set count value.

31. xDSL-Line-Interface-Circuit according to claim 27, wherein the timing device counter (21-5) is connected via said control lines (23) to the at least one timing device of said loop low pass filter (20).

32. xDSL-Line-Interface-Circuit according to claim 31, wherein the capacitance of said loop low pass filter (20) is decreased when the timing device counter (21-5) is incremented for increasing the switching frequency of said loop signal.

33. xDSL-Line-Interface-Circuit according to claim 22, wherein the reference clock signal is a system clock signal.

34. xDSL-Line-Interface-Circuit according to claim 1, wherein the xDSL-Line-Interface-Circuit (1) receives a differential input signal.

35. xDSL-Line-Interface-Circuit according to claim 34, wherein the differential input signal is applied to an analog comparator (6) for generating a reference clock signal which is applied to said trimming circuit (21).

36. xDSL-Line-Interface-Circuit according to claim 35, wherein said analog comparator (6) and said trimming circuit (21) are activated by a Trimming Enable Signal (TE).

37. xDSL-Line-Interface-Circuit according to claim 1, wherein the xDSL-Line-Interface-Circuit (1) comprises a second order demodulation filter (28) connected to said self oscillating loop circuit.

38. xDSL-Line-Interface-Circuit according to claim 1, wherein the xDSL-Line-Interface-Circuit (1) comprises an echo cancellation circuit (13).

39. xDSL-Line-Interface-Circuit according to claim 37, wherein the demodulation filter (8) is connected to an analog adaption circuit (31) for adapting the output impedance of said xDSL-Line-Interface-Circuit (1) to a subscriber line (32).

40. xDSL-Line-Interface-Circuit according to claim 27, wherein the timing device counter (21-5) of said trimming circuit (21) is activated by means of variation enable control signal (VE).

41. xDSL-Line-Interface-Circuit according to claim 40, wherein the variation enable control signal (VE) deactivates the first digital comparator (21-3) of said trimming circuit (21).

42. xDSL-Line-Interface-Circuit according to claim 1, wherein said trimming circuit (21) is a DSP-processor.
